# EUROPÄISCHE PATENTSCHRIFT

(11) **EP 3 421 883 B1**
(45) Veröffentlichungstag und Bekanntmachung des Hinweises auf die Patenterteilung: **24.07.2019**
(21) Anmeldenummer: 18169575.0
(22) Anmeldetag: 26.04.2018
(51) Int. Cl.: F21V 29/503, F21S 4/28, H05K 1/02, F21V 29/507, F21V 3/02, F21V 5/04, H05K 1/05, F21Y 103/10, F21Y 115/10

(54) **LEUCHTE FÜR DIE RAUM- UND GEBÄUDEBELEUCHTUNG**
LUMINAIRE FOR ROOM AND BUILDING LIGHTING
LUMINAIRE POUR ÉCLAIRAGE DE SALLE ET DE BÂTIMENT

(30) Priorität: 27.06.2017 DE 102017114235
(43) Veröffentlichungstag der Anmeldung: 02.01.2019
(73) Patentinhaber: BJB GmbH & Co. KG, 59755 Arnsberg (DE)
(72) Erfinder: Baumeister, Olaf, 59846 Sundern (DE); Pieper, Markus, 59759 Arnsberg (DE)
(74) Vertreter: Ostriga Sonnet Wirths & Vorwerk

(56) Entgegenhaltungen:
- EP-A1- 3 094 161
- DE-U1-202009 011 688
- DE-U1-202013 103 294
- US-A1- 2013 088 863

## Beschreibung

Die Erfindung betrifft eine Leuchte für die Raum- und Gebäudebeleuchtung mit den Merkmalen des Oberbegriffs des Anspruchs 1. Die Erfindung betrifft ferner ein Verfahren zur Herstellung einer Leuchte gemäß Anspruch 8.

Derartige Leuchten sind aus dem Stand der Technik hinlänglich bekannt. So existieren beispielsweise druckschriftlich nicht belegbare Leuchten, die zur Nutzung mit Leuchtstoffröhren oder klassischen Gasentladung- oder Glühlampen zu nutzen waren, die durch sogenannte Retrofitlampen mit LED-Leuchtmitteln nachrüstbar sind.

Leuchten neuerer Bauart sind auf LEDs als Leuchtmittel hin konstruiert. Hier sind die LEDs auf ihren Platinen häufig in der Leuchte integriert. In der Regel wird die auf der Platine aufgebrachte LED auf einen Kühlkörper montiert, welcher in einer der gewünschten Abstrahlcharakteristik entsprechenden Position im Leuchtengehäuse verankert ist.

Als Beispiel für die zuletzt genannte Leuchtenart wird auf beispielsweise die DE 10 2014 000 741 B4 verwiesen.

Diese herkömmliche Art Leuchten zu gestalten gibt dem Leuchtengestalter bzw. -hersteller einen hohen Freiheitsgrad in der Gestaltung des Leuchtengehäuses wie auch in den Möglichkeiten, Leuchtmittel innerhalb der Leuchte für eine bestimmte Abstrahlcharakteristik anzuordnen. Diese großen Freiheitsgrade gehen jedoch mit einem hohen Montage- und Fertigungsaufwand einher, welcher erhöhte Fertigungskosten zur Folge hat.

Aus DE 20 2013 103 294 U1 und DE 20 2009 011 688 U1 ist es bekannt, unverformte Leiterplatten mit lichtdurchlässigen Abdeckungen zu kombinieren, um Leuchten zu erhalten. Die Leiterplatten sind in beiden Offenbarungen zwischen einer Montagefläche und der lichtdurchlässigen Abdeckung angeordnet und somit vor äußeren Einflüssen weitestgehend geschützt.

US 2013/0088 863 A1 zeigt eine Retrofit-Lampe, welche dem Ersatz herkömmlicher Leuchtstoffröhren dient. Eine mit LEDs versehene Leiterplatte ist auf der zum Leuchtengehäuse gewandten Seite der Retrofitlampe angeordnet und in Nuten einer lichtdurchlässigen Abdeckung gehalten. Endkappen mit elektrischen Anschlusselementen bilden die Lampensockel.

EP 3 094 161 A1 zeigt eine Leiterplatte, die insbesondere als flexible Leiterplatte in Form von aufgerollter Endlosware ausgebildet sein kann. Vorgegebene Bereiche sind LED-frei. Die Leiterplatte kann individuell gekürzt werden und ist entlang von Faltlinien faltbar. Die LED-freien Bereiche sind relativ zu den mit LEDS besetzten Bereichen derart ausgerichtet, dass in einem aufgerichteten Zustand ein mit LEDs bestückter Reflektor für den Einsatz in Leuchten bereitgestellt ist.

Aufgabe der Erfindung ist es eine möglichst einfach aufgebaute Leuchte zu schaffen, welche kostengünstig herstellbar ist.

Gelöst wird die Aufgabe von einer Leuchte mit den Merkmalen des Anspruches 1, insbesondere mit dessen kennzeichnenden Merkmalen, wonach die Oberfläche der Metallkernplatine in den vermittels Umformung aus der Anordnungsebene der LED ausgestellten Oberflächenbereichen isolationsschichtfrei ausgebildet ist.

Die Erfindung schlägt vor, eine maximale Bauteilreduktion vorzunehmen und das Leuchtengehäuse von der Metallkernplatine bilden zu lassen, auf welcher die zu Beleuchtungszwecken nötigen LEDs angeordnet sind. Wenn man in technisch korrekter Einordnung die mit den LEDs versehene Platine als das eigentliche Leuchtmittel bezeichnet, zeichnet sich die Erfindung dadurch aus, die Leuchte ausschließlich vom Leuchtmittel gebildet ist. Hierdurch sind zwar die Freiheitsgrade hinsichtlich der Gehäusegestaltung und der Anordnung der LEDs zur Schaffung bestimmter Lichtcharakteristika eingeschränkt, es gibt jedoch eine ganze Reihe Anwendungsbereiche, in denen diese Freiheitsgrade nicht benötigt werden. Als Beispiel seien hier Anwendungsfelder zu nennen, in welchen die Leuchte insbesondere industriellen oder technischen Zwecken dient.

Bei Leuchten in Lagerhallen steht beispielsweise die Ausleuchtung bestimmter Flächen oder Objekte im Vordergrund, das Design der Leuchte selbst ist hingegen zweitrangig.

Auch in beispielsweise Gewächshäusern dienen Leuchten primär dazu, das Pflanzenwachstum zu optimieren. Das Erhellen der Gewächshäuser zur Schaffung einer für den menschlichen Benutzer angenehmen bzw. für dessen Tätigkeit optimierten Beleuchtung ist hingegen zweitrangig und kann im Zweifel durch eine spezielle, zu diesem Zweck optimierte Arbeitsbeleuchtung sichergestellt werden. Im Kern reduziert die Erfindung die Leuchtenherstellung darauf, der Metallkernplatine eine entsprechende Gehäuseform zu geben, was in einer bevorzugten Ausführungsform beispielsweise durch einen Umformprozess erfolgen kann. Sofern der Einsatzzweck der Leuchte keine weiteren besonderen Maßnahmen erfordert, muss nach dem formgebenden Prozess lediglich noch ein Netzanschlusselement an das Leuchtengehäuse angesetzt werden, mittels dessen eine Stromversorgung sichergestellt wird.

Die bislang übliche Anordnung von LED-Platinen in einem Leuchtengehäuse, ggf. unter verschiedenen Winkeln zur Erreichung bestimmter Ausleuchtungscharakteristika, die interne Verdrahtung, das Wärmemanagement über Kühlkörper oder andere Wärmeleitelemente etc. entfällt bei der Erfindung.

Erfindungsgemäß ist vorgesehen, dass die Metallkernplatine durch zumindest einen Umformprozess das Lampengehäuse bildet, wobei in Folge dessen dann bevorzugt von der Metallkernplatine eine zumindest kanalartige Kavität ausgebildet ist, innerhalb der die LED angeordnet ist.

Sodann ist vorgesehen, dass die kanalartige Kavität durch Stirnseitige Abschlussstücke begrenzt ist, die beispielsweise als Lampensockel und/oder Lampenhalter ausgebildet sind, womit durch lediglich minimalen Zusatzaufwand sowohl der Netzanschluss als auch die Befestigung sichergestellt ist.

Vorgesehen ist ferner, dass die vermittels Umformung aus der Anordnungsebene der LED ausgestellten Gehäuseabschnitte der Metallkernplatine der Wärmeabfuhr der LED-Betriebswärme dienen, wobei vorgesehen ist dass die der Wärmeabfuhr der LED-Betriebswärme dienenden Gehäuseabschnitte der Metallkernplatine eine ausreichende Oberflächengröße zur Wärmeabfuhr aufweisen.

Sofern die Einsatzzwecke es erfordern, kann vorgesehen sein, dass die Metallkernplatine Haltemittel für die lichtdurchlässige Abdeckung ausbildet.

Die Aufgabe der Erfindung wird sodann auch gelöst durch ein Verfahren zur Herstellung einer Leuchte, die ein Leuchtengehäuse aufweist, und mit einer Platine, die einer LED als Leuchtmittel trägt, wobei als Platine eine Metallkernplatine genutzt wird, welche entlang wenigstens zweier Umformlinien zu einem Leuchtengehäuse umgeformt wird, wodurch die Platine das Leuchtengehäuse bildet, wobei die LED zwischen den Umformlinien angeordnet ist, dadurch gekennzeichnet, dass die Oberfläche der Metallkernplatine in den vermittels Umformung aus der Anordnungsebene der LED ausgestellten Oberflächenbereichen isolationsschichtfrei und/oder leiterbahnenfrei gehalten wird.

Das Verfahren kann vorsehen, dass die Oberfläche der Metallkernplatine mit Haltemitteln für eine Abdeckung versehen werden.

Weitere Vorteile der Erfindung sowie ein besseres Verständnis derselben werden nunmehr an Hand von detailliert beschriebenen Ausführungsformen dargestellt. Es zeigen:
- Figur 1: eine schematisch dargestellte Teilansicht einer Platine,
- Figur 2: ein aus der Platine gemäß Figur 1 gewonnenes Leuchtengehäuse,
- Figur 3: Darstellung der Montage einer Abdeckung in einem Leuchtengehäuse gemäß Figur 2,
- Figur 4: das Leuchtengehäuse gemäß Figur 3 nach Montage der lichtdurchlässigen Abdeckung,
- Figur 5: Darstellung einer alternativen Ausführungsform des Gehäuses gemäß Figur 4,
- Figur 6: Darstellung einer alternativen Ausführungsform des Gehäuses gemäß Figur 4,
- Figur 7: Darstellung einer alternativen Ausführungsform des Gehäuses gemäß Figur 4,
- Figur 8: Darstellung eines alternativen Gehäuses gemäß Figur 4
- Figur 9: Darstellung eines alternativen Gehäuses gemäß Figur 4 mit einer Vergussmasse als lichtdurchlässige Abdeckung.

In den Figuren wird eine erfindungsgemäße Leuchte insgesamt mit der Bezugsziffer 10 versehen.

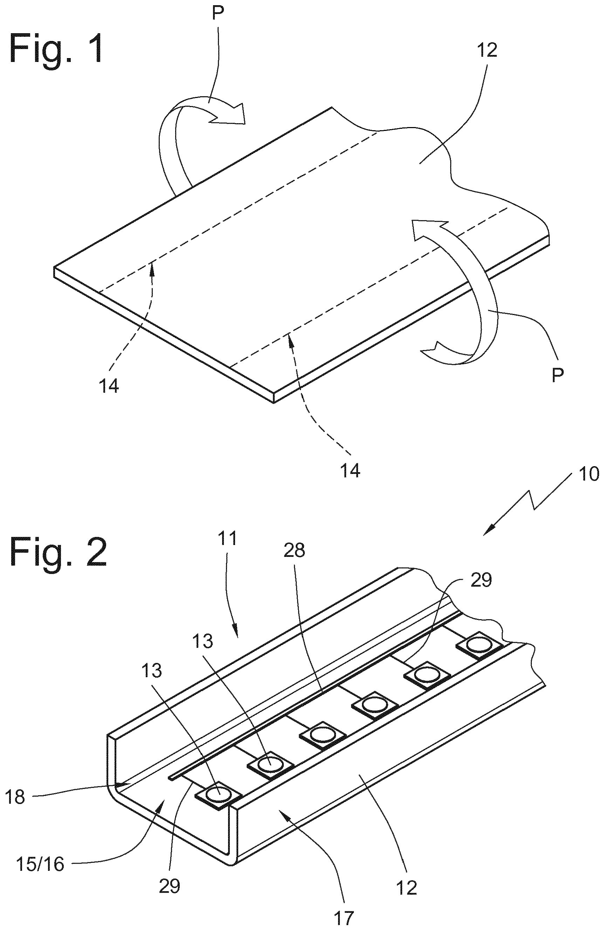

Die Leuchte 10 verfügt über ein Leuchtengehäuse 11, welches aus einer in Figur 1 dargestellten Metallkernplatine 12 hergestellt ist. Die Darstellung der Metallkernplatine 12 in Figur 1 ist stark vereinfacht. Es wurde auf die Darstellung von Leiterbahnen und von auf der Metallkernplatine 12 angeordneten LEDs 13 verzichtet.

Bevorzugt handelt es sich bei der Metallkernplatine 12 um ein flächiges Element, welches entlang zweier Umformlinien 14 umgeformt wird, um das Leuchtengehäuse 11 zu bilden. Im Beispiel sind die Umformlinien 14 parallel zueinander und mit Abstand zueinander angeordnet. Durch ein Umformen entsprechend der mit Pfeilen P illustrierten Umformrichtung U wird das in Figur 2 exemplarisch dargestellte, in etwa kanalartig ausgebildete Leuchtengehäuse 11 der Leuchte 10 erhalten.

Der zwischen den Umformlinien 14 gebildete Anordnungsbereich 15 für LEDs 13 bildet den Kanalboden 16, die durch die Umformung aufgerichteten Abschnitte bilden die Kanalwände 17. Dabei kann die Metallkernplatine 12 entlang der Umformlinien 14 vor dem Umformvorgang mit Materialschwächungszonen 18 versehen sein, wodurch der Umformvorgang vereinfacht wird. Schematisch dargestellte Leiterbahnen 28 und 29 dienen der Spannungsversorgung der LEDs.

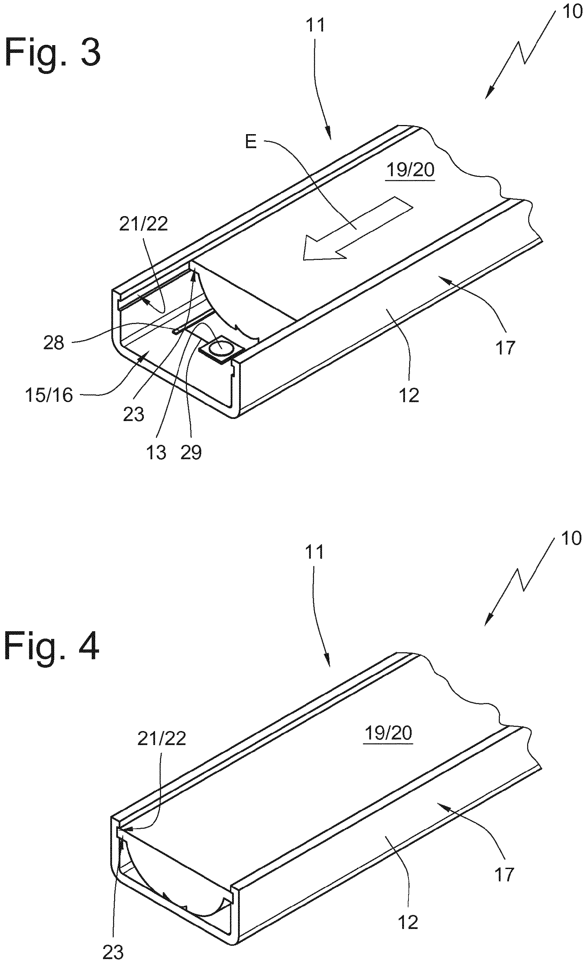

Sofern die Einsatzzwecke es verlangen, kann die Leuchte 10 eine lichtdurchlässige Abdeckung 19 aufweisen, die im Ausführungsbeispiel gemäß der Figuren 3 und 4 zudem als Optik 20 ausgebildet ist und die Verteilung des von den LED 13 emittierten Lichtes beeinflusst.

Zur Anordnung der Optik 20 im Leuchtengehäuse 11 der Ausführungsform gemäß den Figuren 3 und 4 sind die einander zugewandten Oberflächen der Kanalwände 17 jeweils mit einem Halteelement 21 versehen, bei dem es sich im Ausführungsbeispiel der Figuren 3 und 4 um eine Haltenut 22 handelt. In diese Haltenut 22 greifen Halteschenkel 23 der Optik 20 ein, so dass die Optik 20 entlang der Längsachse der Leuchte 10 in das Leuchtengehäuse 11 einschiebbar ist, wie es der Einschubpfeil E symbolisiert.

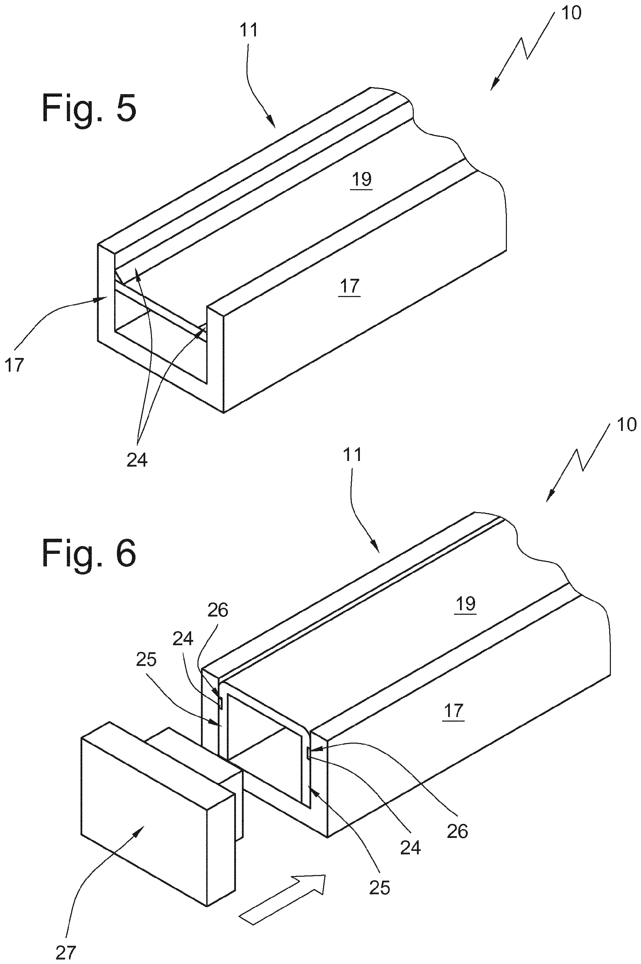

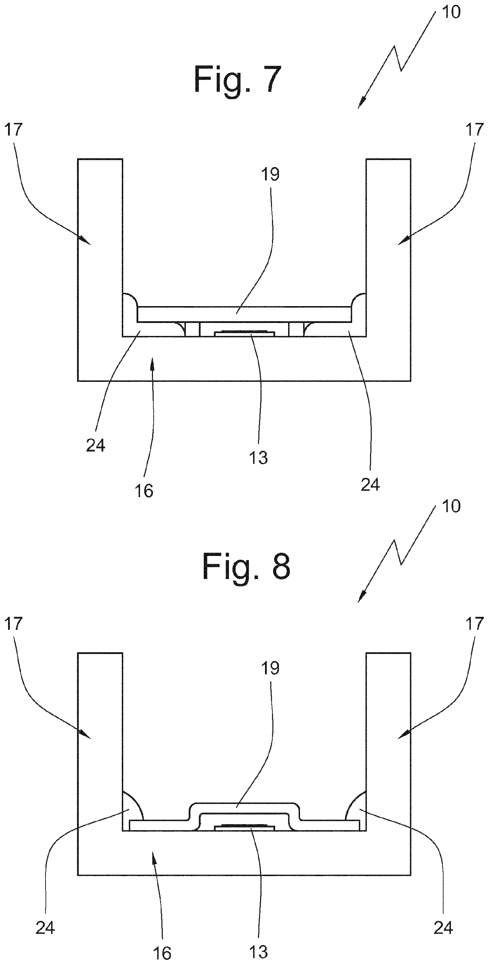

Alternative Ausführungsformen der Leuchte 10 sind in den Figuren 5 bis 8 dargestellt. Figur 5 eine Leuchte 10, deren lichtdurchlässige Abdeckung 19 in ihren Anordnungsbereichen an den Kanalwänden 17 des Leuchtengehäuses 11 mit einem Dichtmaterial 24 versehen ist, wobei hier das Dichtmaterial 24 auch der mechanischen Festlegung des Abdeckelementes 19 dienen kann. Es kann sich bei dem Dichtmaterial 24 in Figur 5 beispielsweise um einen Kleber mit abdichtender Funktion handeln. Alternative Varianten hierzu sind in den Figuren 7 und 8 dargestellt. Auch hier kann das Dichtmaterial 24 ein Kleber sein. Anderenfalls ist es denkbar, dass die lichtdurchlässige Abdeckung 19 jeweils in das Dichtmaterial 24 eingepresst ist und insofern reibschlüssig gehalten ist.

Figur 6 zeigt eine Ausführungsform der Leuchte 10, bei welcher die lichtdurchlässige Abdeckung 19 ebenfalls als kanalartiges Element ausgeführt ist. Dieses ist an seinen Kanalwänden 25 mit je einer Aufnahmenut 26 versehen, welche in Richtung Kanalwand 17 der Leuchte 10 weist. In dieser Kanalwand ist das Dichtmaterial 24 eingesetzt.

Figur 6 dient darüber hinaus der schematischen Illustration der Endfertigung der Leuchte 10. Stirnkappen 27 werden stirnseitig auf das Leuchtengehäuse 11 aufgesetzt, um die stirnseitigen Öffnungen der kanalartigen Vertiefung des Leuchtengehäuses zu verschließen. Diese Stirnkappe 27 können dabei als Anschlussbauteil ausgebildet sein, über welches die Leuchte 10 mit Elektrizität versorgt wird. Darüber hinaus kann die Stirnkappen 27 der Halterung der Leuchte 10 an geeigneten Gegenstücken dienen.

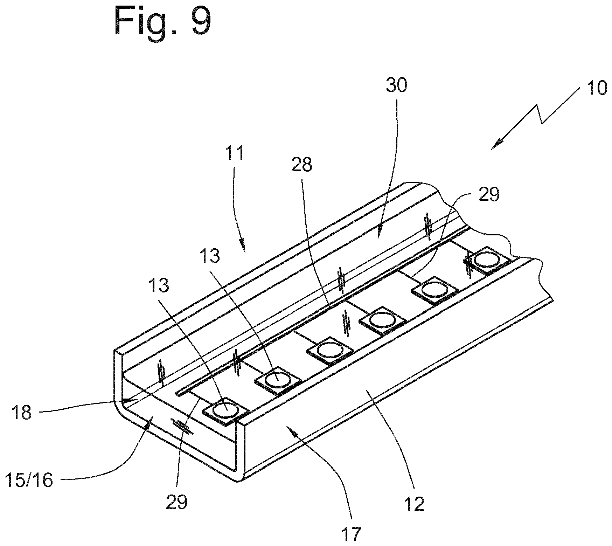

In Figur 9 ist eine Ausführungsform dargestellt, bei welcher die lichtdurchlässige Abdeckung 19 (nicht bezeichnet) von einer transparenten Vergussmasse gebildet ist. Diese wird in das kanalartige Leuchtengehäuse 11 eingegossen und härtet anschließend aus. Auf diese Weise werden die LEDs 13 hermetisch gegen die Außenumgebung versiegelt, so dass ein Höchstmaß an Schutz vor Feuchtigkeit und Verschmutzung erreicht wird.

Zusammenfassend offenbart die Erfindung eine ausgesprochen einfach herzustellende Leuchte 10, die sich insbesondere für vornehmlich technische Einsatzzwecke eignet. Da die Leuchte 10 im Wesentlichen allein von der Metallkernplatine 12 des Leuchtmittels gebildet wird, entfallen eine ganze Reihe von dem im Stand der Technik notwendigen Fertigungs- und Montageschritten, so dass die vorgestellte Leuchte 10 ausgesprochen effizient und kostengünstig herstellbar ist.

### Bezugszeichenliste

- 10: Leuchte
- 11: Leuchtengehäuse
- 12: Metallkernplatine
- 13: LED
- 14: Umformlinie
- 15: Anordnungsbereich
- 16: Kanalboden
- 17: Kanalwand
- 18: Materialschwächungszone
- 19: lichtdurchlässige Abdeckung
- 20: Optik
- 21: Halteelement
- 22: Haltenut
- 23: Halteschenkel
- 24: Dichtmaterial
- 25: Kanalwand
- 26: Aufnahmenut
- 27: Stirnkappe
- 28: Leiterbahn
- 29: Leiterbahn
- P: Pfeil
- U: Umformrichtung
- E: Einschubpfeil

## Patentansprüche

1. Leuchte (10) für die Raum- und Gebäudebeleuchtung, aufweisend ein Leuchtmittel,
- mit einer Platine, die ein Trägermaterial, eine auf das Trägermaterial zumindest einseitig aufgebrachte Isolationsschicht, auf der Isolationsschicht aufgebrachte Leiterbahnen und zumindest eine auf der Isolationsschicht angeordnete, als Leuchtmittel dienende LED (13) aufweist,
- mit zumindest einer lichtdurchlässigen Abdeckung, die der LED (13) in Lichtaustrittsrichtung nachgeordnet ist,
- mit einem Leuchtengehäuse (11),
wobei
- die Platine eine Metallkernplatine (12) ist, welche selbst das Leuchtengehäuse (11) ausbildet,
- die Metallkernplatine (12) durch zumindest einen Umformprozess das Leuchtengehäuse (11) bildet
- das Leuchtengehäuse (11) durch Umformen entlang zumindest zweier Umformlinien (14) der Metallkernplatine (12) erhalten ist, zwischen denen sich eine Isolationsschicht mit den Leiterbahnen und der LED (13) befinden,
**dadurch gekennzeichnet, dass**
- die Oberfläche der Metallkernplatine (12) in den vermittels Umformung aus der Anordnungsebene der LED (13) ausgestellten Oberflächenbereichen isolationsschichtfrei ausgebildet ist.

2. Leuchte nach Anspruch 1, **dadurch gekennzeichnet, dass** der Umformprozess ein Biegeprozess ist.

3. Leuchte nach Anspruch 2, **dadurch gekennzeichnet, dass** die vermittels Umformung aus der Anordnungsebene der LED (13) ausgestellten Gehäuseabschnitte der Metallkernplatine (12) der Wärmeabfuhr der LED-Betriebswärme dienen.

4. Leuchte nach Anspruch 3, **dadurch gekennzeichnet, dass** die der Wärmeabfuhr der LED-Betriebswärme dienenden Gehäuseabschnitte der Metallkernplatine (12) eine ausreichende Oberflächengröße zur Wärmeabfuhr aufweisen.

5. Leuchte nach einem der vorhergehenden Ansprüche, **dadurch gekennzeichnet, dass** die Metallkernplatine (12) eine zumindest kanalartige Kavität aufweist, innerhalb derer die LED (13) angeordnet ist.

6. Leuchte nach Anspruch 5, **dadurch gekennzeichnet, dass** die kanalartige Kavität durch Stirnseitige Abschlussstücke begrenzt ist, die beispielsweise als Lampensockel und/oder Lampenhalter ausgebildet sind.

7. Leuchte nach einem der vorhergehenden Ansprüche, **dadurch gekennzeichnet, dass** die Metallkernplatine (12) Haltemittel für die lichtdurchlässige Abdeckung (19) ausbildet.

8. Verfahren zur Herstellung einer Leuchte (10), die ein Leuchtengehäuse (11) aufweist, und mit einer Platine, die einer LED (13) als Leuchtmittel trägt, wobei
- als Platine eine Metallkernplatine (12) genutzt wird, welche entlang wenigstens zweier Umformlinien zu einem Leuchtengehäuse (11) umgeformt wird, wodurch die Platine das Leuchtengehäuse (11) bildet, wobei die LED (13) zwischen den Umformlinien angeordnet ist, **dadurch gekennzeichnet, dass**
- die Oberfläche der Metallkernplatine (12) in den vermittels Umformung aus der Anordnungsebene der LED (13) ausgestellten Oberflächenbereichen isolationsschichtfrei gehalten wird.

9. Verfahren nach Anspruch 8, **dadurch gekennzeichnet, dass** die Oberfläche der Metallkernplatine (12) mit Haltemitteln für eine Abdeckung versehen werden.

## Claims

1. Luminaire (10) for room and building illumination, comprising a light source,
- having a printed circuit board which comprises a carrier material, an insulation layer applied to the carrier material at least on one side, conductive tracks applied to the insulation layer, and at least one LED (13) which is arranged on the insulation layer and which serves as the light source,
- having at least one light-permeable cover which is arranged after the LED (13) in a light exit direction,
- having a luminaire housing (11),
wherein
- the printed circuit board is a metal core printed circuit board (12) which itself forms the luminaire housing (11),
- the metal core printed circuit board (12) forms the luminaire housing (11) through at least one forming process,
- the luminaire housing (11) is obtained by forming along at least two forming lines (14) of the metal core printed circuit board (12), between which an insulation layer is located together with the conductive tracks and the LED (13),
**characterised in that**
- the surface of the metal core printed circuit board (12) is configured so as to be free of insulation layer in the surface regions which, by means of the forming, are moved out of the plane in which the LED (13) is arranged.

2. Luminaire according to claim 1, **characterised in that** the forming process is a bending process.

3. Luminaire according to claim 2, **characterised in that** the housing portions of the metal core printed circuit board (12) which, by means of the forming, are moved out of the plane in which the LED (13) is arranged serve for dissipating the heat of operation of the LED.

4. Luminaire according to claim 3, **characterised in that** the housing portions of the metal core printed circuit board (12) which serve for dissipating the heat of operation of the LED have a surface size sufficient for dissipating the heat.

5. Luminaire according to one of the preceding claims, **characterised in that** the metal core printed circuit board (12) has an at least channel-like cavity, within which the LED (13) is arranged.

6. Luminaire according to claim 5, **characterised in that** the channel-like cavity is delimited by terminal pieces at the ends, which are configured for example as a lamp socket and/or lamp holder.

7. Luminaire according to one of the preceding claims, **characterised in that** the metal core printed circuit board (12) forms retaining means for the light-permeable cover (19).

8. Method for producing a luminaire (10), which comprises a luminaire housing (11), and having a printed circuit board which carries an LED (13) as light source, wherein
- the printed circuit board used is a metal core printed circuit board (12) which is formed along at least two forming lines to create a luminaire housing (11), as a result of which the printed circuit board forms the luminaire housing (11), wherein the LED (13) is arranged between the forming lines,
**characterised in that**
- the surface of the metal core printed circuit board (12) is kept free of insulation layer in the surface regions which, by means of the forming, are moved out of the plane in which the LED (13) is arranged.

9. Method according to claim 8, **characterised in that** the surface of the metal core printed circuit board (12) are provided with retaining means for a cover.

## Revendications

1. Luminaire (10) pour l'éclairage de pièce et de bâtiment, comprenant un moyen d'éclairage, comportant :
- une carte de circuit imprimé qui comprend un matériau support, une couche isolante appliquée au moins sur un côté du matériau support, des pistes appliquées sur la couche isolante et au moins une DEL (13), servant de moyen d'éclairage, disposée sur la couche isolante,
- au moins un couvercle translucide, qui est disposé en aval de la DEL (13) dans le sens de la sortie de la lumière,
- un boîtier de luminaire (11),
dans lequel
- la carte de circuit imprimé est une carte à âme métallique (12) qui constitue elle-même le boîtier de luminaire (11),
- la carte à âme métallique (12) forme par au moins un process de formage le boitier de luminaire (11),
- le boitier de luminaire (11) est obtenu par formage le long au moins de deux lignes de formage (14) de la carte à âme métallique (12) entre lesquelles se trouve une couche isolante comportant les pistes et la DEL (13),
**caractérisé en ce que** la surface de la carte à âme métallique (12) est réalisée exempte de couche isolante dans les zones de surface exposées par formage en dehors du plan de disposition de la DEL (13).

2. Luminaire selon la revendication 1, **caractérisé en ce que** le process de formage est un process de cintrage.

3. Luminaire selon la revendication 2, **caractérisé en ce que** les sections du boitier, exposées par formage en dehors du plan de disposition de la DEL (13), de la carte à âme métallique (12) servent à l'évacuation thermique de la chaleur de fonctionnement de la DEL.

4. Luminaire selon la revendication 3, **caractérisé en ce que** les sections du boîtier, servant à l'évacuation thermique de la chaleur de fonctionnement de la DEL, de la carte à âme métallique (12) comportent une taille de surface suffisante pour évacuer la chaleur.

5. Luminaire selon l'une des précédentes revendications, **caractérisé en ce que** la carte à âme métallique (12) comporte au moins une cavité en forme de canal, au sein de laquelle est disposée la DEL (13).

6. Luminaire selon la revendication 5, **caractérisé en ce que** la cavité en forme de canal est limitée par des parties de terminaison frontales qui sont réalisées, par exemple, en tant que socle de lampe et/ou porte-lampe.

7. Luminaire selon l'une des précédentes revendications, **caractérisé en ce que** la carte à âme métallique (12) constitue des moyens de maintien pour le couvercle (19) translucide.

8. Procédé pour la fabrication d'un luminaire (10), qui comprend un boitier de luminaire (11) et une carte de circuit imprimé qui porte une DEL (13) servant de moyen d'éclairage, dans lequel
- une carte à âme métallique (12) est utilisée en tant que carte de circuit imprimé, qui est formée le long au moins de deux lignes de formage en un boîtier de luminaire (11), la platine formant le boîtier de luminaire (11), la DEL (13) étant disposée entre les lignes de formage, **caractérisé en ce que** la surface de la carte à âme métallique (12) est tenue exempte de couche isolante dans les zones de surface exposées par formage en dehors du plan de disposition de la DEL (13).

9. Procédé selon la revendication 8, en ce que la surface de la carte à âme métallique (12) est munie de moyens de maintien pour un couvercle.
